# FASCICULE DE BREVET EUROPEEN

(11) **EP 0 747 856 B1**
(45) Date de publication et mention de la délivrance du brevet: **21.04.1999**
(21) Numéro de dépôt: 96401188.6
(22) Date de dépôt: 04.06.1996
(51) Int. Cl.: G06T 9/00

(54) **Décodeur MPEG**
MPEG Dekoder
MPEG decoder

(30) Priorité: 09.06.1995 FR 9506864
(43) Date de publication de la demande: 11.12.1996
(73) Titulaire: STMicroelectronics S.A., 94253 Gentilly Cédex (FR)
(72) Inventeur: Bramley, Richard, 38000 Grenoble (FR)
(74) Mandataire: Michelet, Alain

(56) Documents cités:
- EP-A- 0 503 956
- EP-A- 0 572 263
- ELETTRONICA OGGI, 30 JUNE 1995, ITALY, no. 201, ISSN 0391-6391, pages 69, 70, 72-73, XP002008641 ZANNOLI S: "An MPEG-1 development kit"
- SMPTE JOURNAL, FEB. 1995, USA, vol. 104, no. 2, ISSN 0036-1682, pages 62-72, XP002008642 STOJANCIC M M ET AL: "Architecture and VLSI implementation of the MPEG-2:MP ML video decoding process"
- ICASSP-92: 1992 IEEE INTERNATIONAL CONFERENCE ON ACOUSTICS, SPEECH AND SIGNAL PROCESSING (CAT. NO.92CH3103-9), SAN FRANCISCO, CA, USA, 23-26 MARCH 1992, ISBN 0-7803-0532-9, 1992, NEW YORK, NY, USA, IEEE, USA, pages 661-664 vol.5, XP002008643 TAMITANI I ET AL: "An encoder/decoder chip set for the MPEG video standard"
- 1993 IEEE INTERNATIONAL SOLID-STATE CIRCUITS CONFERENCE. DIGEST OF TECHNICAL PAPERS. ISSCC. FIRST EDITION (CAT. NO.93CH3272-2), PROCEEDINGS OF IEEE INTERNATIONAL SOLID-STATE CIRCUITS CONFERENCE - ISSCC '93, SAN FRANCISCO, CA, USA, 24-26 FEB. 1993, ISBN 0-7803-0987-1, 1993, NEW YORK, NY, USA, IEEE, USA, pages 34-35, XP002008644 BRINTHAUPT D ET AL: "A video decoder for H.261 video teleconferencing and MPEG stored interactive video applications"

## Description

La présente invention concerne un dispositif de décodage d'un flux de données représentant des images animées codées selon la norme MPEG.

Les normes MPEG concernent le codage et le décodage d'images animées.

Les techniques de transmission et le stockage d'images numérisées permettent d'améliorer de manière significative la qualité des images finalement obtenues par rapport à la transmission analogique. Il est ainsi possible de multiplier également les applications de ces techniques.

Toutefois, la transmission directe et le stockage d'images numérisées animées nécessite un flux d'informations extrêmement élevé, ce qui rend nécessaire, en pratique, la compression et le codage de ces images.

Ainsi, les images numérisées sont codées avant transmission, de manière à diminuer la quantité d'informations les représentant, puis décodées après transmission.

Les techniques de codage et décodage sont bien entendu essentielles pour la qualité des images finalement obtenues et il est apparu nécessaire, pour assurer la compatibilité des différents matériels mettant en oeuvre ces techniques, d'en assurer une normalisation.

C'est ainsi qu'un groupe d'Experts (Moving Picture Expert Group - MPEG) a mis au point les normes ISO 11172 et ISO IEC 13818.

Ces normes souvent désignées par les sigles MPEG1 et MPEG2 définissent des conditions de codage et de décodage d'images animées, éventuellement associées à un signal sonore, pouvant être utilisées aussi bien pour la mise en mémoire et la restitution d'images que pour leur transmission.

Cette norme MPEG peut donc être utilisée pour le stockage d'images sur des compact discs, compact discs interactifs, sur des bandes magnétiques, être utilisée pour la transmission d'images au travers de réseaux locaux, de lignes téléphoniques comme pour la transmission d'images télévision par voie hertzienne.

La norme définissant de manière complète et détaillée l'ensemble de cette technique est accessible auprès des organismes de normalisation et il convient de s'y référer pour accéder à sa description détaillée.

La compression de données mise -en oeuvre selon la norme MPEG peut suivre plusieurs traitements.

Les images consécutives sont tout d'abord collectées, de manière à former un groupe d'images formant une séquence. Une séquence est donc subdivisée en groupes d'images.

Chaque image est divisée en tranches, chaque tranche étant elle-même décomposée en macro-blocs qui constituent l'élément de base utilisé pour appliquer une compensation de mouvements et pour changer, éventuellement, l'échelle de quantification.

Les macro-blocs sont formés d'une matrice 16 x 16 d'éléments d'image (pixels).

Chaque macro-bloc est divisé en six blocs, les quatre premiers portant une information de luminance et les deux autres portant chacun une information de chrominance.

Chacun de ces six blocs est défini comme étant une matrice de 8 x 8 éléments d'images (pixels).

A l'intérieur de chaque séquence, différents types d'images sont définis, de manière à réduire la quantité d'informations à stocker ou à transmettre en raison des analogies existantes entre les informations contenues dans les différentes images d'une même séquence.

Les images I (Intra frames) sont des images codées sans référence à une autre image.

Les images P (Predicted) sont déduites à partir de l'image I ou P précédemment reconstruite.

Les images B (Bi-directional frames) sont déduites de deux images I et P ou P et P reconstruites, l'une juste avant et l'autre juste après.

Il faut souligner ici que, généralement, l'ordre de transmission des images d'une séquence ne correspond pas à leur ordre de présentation lors de l'acquisition ou de la restitution. Elles sont dans l'ordre de décodage.

La transformation discrète en cosinus (Discrete Cosine Transformation - DCT) est appliquée au niveau des blocs.

Cette transformation DCT transforme des blocs spatiaux, définis comme nous l'avons indiqué plus haut en une matrice 8 x 8 de pixels, en des blocs temporels formés d'une matrice également 8 x 8, de fréquences spatiales.

On a montré que dans la matrice 8 x 8 du bloc temporel, le coefficient de fonds continu (DC) placé en haut à gauche dans la matrice est beaucoup plus important, pour l'impression visuelle obtenue, que les autres composants correspondant à différentes fréquences.

Plus précisément, plus la fréquence est élevée, moins l'oeil y est sensible.

C'est la raison pour laquelle on quantifie les niveaux des fréquences, d'autant plus que les fréquences sont élevées. Cette quantification est assurée par un algorithme qui n'est pas imposé par la norme, qui comporte une opération de quantification et de codage à longueur variable (Variable Length Coding - VLC).

La matrice dans le domaine fréquentiel obtenue par la transformation DCT est ensuite traitée par une matrice dite "matrice de quantification" qui est utilisée pour diviser chacun des termes de la matrice du domaine temporel par une valeur dépendant de sa position et prenant en compte le fait que le poids des différentes fréquences représentées par ces coefficients est variable.

Le résultat de cette opération conduit, après que chacune des valeurs ait été arrondie à la valeur entière la plus proche, à un nombre important de coefficients égal à zéro.

Il faut souligner que, pour les macro-blocs intra, la valeur de quantification du coefficient de fond (DC) est constante, par exemple égale à 8. Les coefficients de fréquence non nuls sont alors codés selon un balayage en zigzag, par référence à une table de Huffman, donnant à chacun des coefficients de la matrice une valeur codée de longueur variable, et réduisant le volume d'information.

De préférence, les coefficients représentant le fonds continu sont transmis après quantification et, par ailleurs, la matrice de quantification est optimisée, de manière à ce que le volume d'informations soit inférieur à un niveau prédéterminé correspondant aux possibilités de stockage ou de transmission, sans que cela porte atteinte de manière excessive à la qualité de l'information transmise.

Les images de type I sont codées sans l'utilisation de vecteur de mouvement.

Au contraire, les images de type P et B utilisent, au moins pour certains des macro-blocs qui les composent, des vecteurs de mouvement permettant d'augmenter l'efficacité du codage et indiquant de quelle partie de la ou des images de référence, un macro-bloc particulier de l'image considérée doit être déduit.

La recherche du vecteur de mouvement fait l'objet d'une optimisation lors du codage et il est lui-même codé en utilisant la technique DPCM qui exploite au mieux la corrélation existante entre les vecteurs de mouvement des différents macro-blocs d'une même image. Ils font finalement l'objet d'un codage à longueur variable (VLC).

Toutes les informations concernant une séquence codée forment le flux d'informations numériques (bitstream) qui est soit enregistré, soit transmis.

Un tel flux d'informations numériques commence par un en-tête de séquence contenant un certain nombre d'informations et de paramètres dont les valeurs sont maintenues pour l'ensemble de la séquence.

De même, la séquence étant décomposée en groupes d'images, chacun de ces groupes est précédé par un en-tête de groupe et les données représentant chaque image sont elles-mêmes précédées d'un en-tête d'image.

Un système de réception conforme à la norme MPEG reçoit donc un flux de données ou d'informations numériques sous forme de codes de longueur variable représentant les images. Ce flux de données comporte également des tables de longueur de code, des tables de décodage des codes à longueur variable permettant au système de réception de transformer le flux de données en la succession d'images animées qui a été initialement codée.

Comme nous l'avons vu plus haut, le flux de données comporte également des vecteurs mouvements.

Le document EP - A - 0 572 263 décrit un décodeur MPEG dans lequel un processeur central interne contrôle un certain nombre de coprocesseurs à travers un bus commun. Les coprocesseurs comportent, entre autres, une interface pour recevoir le flux de données encodé d'un processeur externe, un contrôleur de mémoire externe DRAM et un décodeur/décompresseur VLC (Variable Length Code) de codes à longueur variable. Le contrôleur de mémoire alloue à chaque coprocesseur un étage de décalage FIFO (First In First Out) afin de servir de tampon à ce coprocesseur. Au niveau du décodage de codes à longueur variable, le décodeur/décompresseur est associé à un étage de décalage spécifique et gère les transferts avec ledit étage de décalage.

D'autre part, le document: SMPTE JOURNAL, FEB. 1995, USA, vol. 104, no. 2, ISSN 0036-1682, pages 62-72, XP002008642 STOJANCIC M M ET AL: "Architecture and VLSI implementation of the MPEG-2:MP@ML video decoding process", décrit un décodeur MPEG similaire comprenant un processeur central interne qui commande, entre autres, un décodeur Huffmann de codes à longueur variable et une interface de mémoire externe DRAM. L'étage de décalage d'entrée (input FIFO) est géré par rapport à un processeur extérieur (host processor).

Dans les dispositifs connus à ce jour, une unité de traitement reçoit le flux de données d'un étage de décalage des données et procède elle-même à l'extraction de la longueur de chaque code, ainsi qu'à son décodage.

Compte tenu du flux d'informations qui doit être traité pour produire des images ayant une définition spatiale suffisante et en nombre suffisamment important pour donner une impression de mouvement continu, les différentes opérations de décodage doivent être réalisées à une très grande vitesse.

Les inventeurs ont fait ressortir que les opérations d'extraction de longueur des codes et de décodage faites par l'unité de traitement, telle qu'indiquée plus haut, sont un point important susceptible de limiter la vitesse de traitement de l'ensemble de décodage.

L'objet de la présente invention est un dispositif alternatif permettant d'augmenter la vitesse de réalisation de ces opérations, sans qu'il soit nécessaire de mettre en oeuvre pour cela des moyens importants et donc coûteux.

A cet effet, l'invention concerne un dispositif de décodage d'un flux de données représentant des images animées codées selon la norme MPEG dans lequel une unité logique reçoit d'un étage de décalage des données comportant le nombre maximum de bits d'un code de longueur variable, renvoie à l'étage de décalage la longueur de chaque code décodé et produit une valeur décodée de chaque code.

Ce dispositif de décodage comporte un contrôleur commandant au moins deux unités de traitement séparées, dont, selon l'invention une première unité de traitement extrait la longueur de chaque code et l'adresse à l'étage de décalage, et une deuxième unité de traitement procède au décodage des codes, les unités de traitement étant contrôlées par l'unité logique.

Selon différents modes de réalisation préférés, ce dispositif de décodage comporte les caractéristiques suivantes, éventuellement combinées :
- le flux de données contenant une table de longueur des codes, le contrôleur extrait du flux de données les paramètres définissant la table de longueur des codes et adresse cette table à la première unité de traitement ;
- le flux de données contenant une table de décodage des codes à longueur variable, le contrôleur extrait du flux de données les paramètres définissant la table de décodage des codes à longueur variable et l'adresse à la deuxième unité de traitement ;
- le flux de données contenant des vecteurs mouvements, il comporte une troisième unité de traitement réalisant le décodage des vecteurs mouvements ;
- chaque unité de traitement est contrôlée par le contrôleur dans un rapport maître/esclave, le contrôleur adressant une commande de début pour commander un traitement dans une unité de traitement et celle-ci renvoyant au contrôleur un signal de fin, lorsque le traitement est terminé ;
- chaque unité de traitement reçoit les données provenant de l'étage de décalage en même temps que celles-ci sont reçues par le contrôleur ;
- le contrôleur contrôle l'émission des signaux après décodage.

L'invention sera décrite en détail en référence aux dessins annexés, dans lesquels :

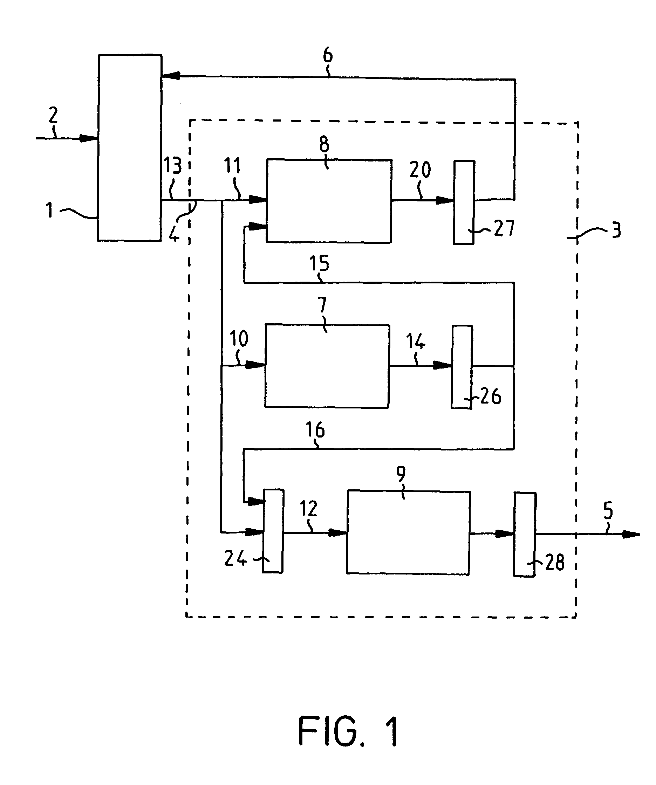

- la Figure 1 est une représentation schématique du dispositif de l'invention dans un premier mode de réalisation ;
- la Figure 2 est une représentation schématique de l'invention dans un deuxième mode de réalisation.

L'étage de décalage 1 reçoit un flux de données 2 représentant des images animées codées selon l'une des normes MPEG.

Le flux de données est donc constitué d'une succession de séquences contenant chacune à la fois des en-têtes porteurs d'informations diverses et des données directement représentatives, sous forme codée, des images.

Le dispositif de décodage 3 reçoit les informations 4 provenant de l'étage de décalage et émet des valeurs de données décodées 5 destinées à l'étage suivant du dispositif de visualisation d'images, et une information 6 de la longueur de chaque code décodé, adressée à l'étage de décalage de manière à lui permettre d'accéder et de traiter le code suivant.

Le dispositif de décodage 3 comporte un contrôleur 7, une première unité 8 de traitement destinée à extraire la longueur du code et une deuxième unité 9 de traitement produisant la valeur décodée de chaque code. 26, 27, 28 sont des bascules de temporisation placées à leur sortie.

Les entrées 10, 11 et 12, respectivement du contrôleur 7 et des deux unités 8 et 9 de traitement, sont reliées à la sortie 13 de l'étage de décalage et reçoivent donc les signaux représentatifs de chaque code.

Le contrôleur 7 est programmé de manière à pouvoir reconnaître les différents types de signaux constitutifs du flux de données MPEG et il est relié par sa sortie 14 à des entrées de commande, respectivement 15 et 16, des unités de traitement qu'il peut donc ainsi contrôler. L'entrée 16 est reliée à un circuit "Et" 24. Les unités 8 et 9 de traitement ont chacune une capacité mémoire leur permettant de stocker, d'une part, une table de longueur des codes en ce qui concerne la première unité de traitement qui a pour fonction d'extraire la longueur du code et, d'autre part, une table de décodage des codes à longueur variable pour ce qui est de la deuxième unité de traitement 9 destinée à procéder à ce décodage.

Le contrôleur 7, lorsqu'il reconnaît dans les signaux reçus de l'étage de décalage 1 de telles tables, procède à leur mise à jour en les adressant à l'unité de traitement 8, 9 voulue.

L'unité 8 de traitement peut ainsi extraire la longueur du code et adresser par sa sortie 20, la commande de décalage à l'étage de décalage 1 nécessaire pour accéder au code suivant, pendant que l'unité 9 de traitement procède au décodage.

Ainsi, les différentes fonctions du dispositif de décodage sont réparties entre le contrôleur 7 lui-même, l'unité 8 de traitement de longueur et l'unité 9 de traitement de décodage, ce qui permet d'obtenir un fonctionnement extrêmement rapide de ce dispositif.

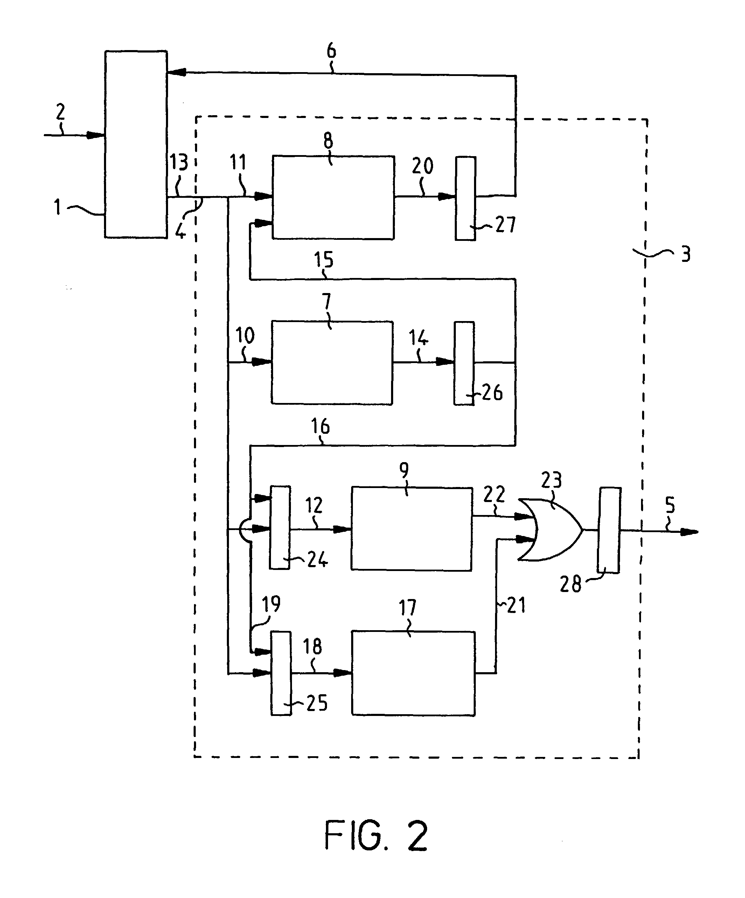

Avantageusement, tel que représenté sur la Figure 2, le dispositif de décodage comporte une unité 17 de traitement supplémentaire recevant également les codes sur son entrée 18 commandée par le contrôleur 7 qui est relié à son entrée de commande 19. La sortie d'un circuit "Ou" 23 dont les entrées sont reliées respectivement à la sortie 21 de l'unité 17 et à la sortie 22 de l'unité 9, constitue alors la sortie 5 du dispositif de décodage. Cette unité 17 de traitement est destinée au traitement des vecteurs mouvements. Il est également commandé par le contrôleur 7 dont il reçoit les tables de décodage de vecteurs mouvements.

Chaque unité 8, 9, 17 de traitement est avantageusement contrôlée par le contrôleur 7 dans un rapport maître/esclave. Le contrôleur 7 adresse à chaque unité de traitement une commande de début lorsqu'elle a reconnu un code qui lui est destiné, et l'unité de traitement renvoie au contrôleur un signal de fin lorsqu'il a terminé son opération.

Dans un mode de réalisation préféré, le contrôleur commande également une unité de stockage 21 et contrôle ainsi des signaux après décodage.

## Revendications

1. Dispositif de décodage d'un flux (2) de données représentant des images animées codées selon la norme MPEG dans lequel une unité logique reçoit d'un étage de décalage des données comportant le nombre maximum de bits d'un code de longueur variable, renvoie à l'étage de décalage la longueur de chaque code décodé et produit une valeur décodée de chaque code, l'unité logique comportant un contrôleur (7) commandant au moins deux unités (8, 9) de traitement séparées,
caractérisé en ce qu'une première unité (8) de traitement extrait la longueur de chaque code et l'adresse à l'étage de décalage, et une deuxième unité (9) de traitement procède au décodage des codes.

2. Dispositif de décodage selon la revendication 1, caractérisé en ce que le flux (2) de données contenant une table de longueur des codes, le contrôleur (7) extrait du flux (2) de données les paramètres définissant la table de longueur des codes et adresse cette table à la première unité (8) de traitement.

3. Dispositif de décodage selon l'une quelconque des revendications 1 et 2, caractérisé en ce que le flux (2) de données contenant une table de décodage des codes à longueur variable, le contrôleur (7) extrait du flux (2) de données les paramètres définissant la table de décodage des codes à longueur variable et l'adresse à la deuxième unité (9) de traitement.

4. Dispositif de décodage selon l'une quelconque des revendications 1 à 3, caractérisé en ce que le flux (2) de données contenant des vecteurs mouvements, il comporte une troisième unité (17) de traitement réalisant le décodage des vecteurs mouvements.

5. Dispositif de décodage selon l'une quelconque des revendications 1 à 4, caractérisé en ce que chaque unité (8, 9, 17) de traitement est contrôlée par le contrôleur (7) dans un rapport maître/esclave, le contrôleur (7) adressant une commande de début pour commander un traitement dans une unité (8, 9, 17) de traitement et celle-ci renvoyant au contrôleur (7) un signal de fin, lorsque le traitement est terminé.

6. Dispositif de décodage selon l'une quelconque des revendications 1 à 5, caractérisé en ce que chaque unité (8, 9, 17) de traitement reçoit les données provenant de l'étage de décalage en même temps que celles-ci sont reçues par le contrôleur (7).

7. Dispositif de décodage selon l'une quelconque des revendications 1 à 6, caractérisé en ce que le contrôleur (7) contrôle l'émission des signaux après décodage.

8. Dispositif de décodage selon l'une quelconque des revendications 1 à 7, caractérisé en ce que le contrôleur (7) est tel que la première unité (8) de traitement extrait la longueur de chaque code et l'adresse à l'étage de décalage, pendant que la deuxième unité (9) de traitement procède au décodage.

## Patentansprüche

1. Decodiervorrichtung für einen Datenfluß (2), der Trickbilder, die nach der Norm MPEG codiert sind, darstellt, bei der eine logische Einheit von einer Verschiebestufe Daten erhält, die die maximale Bitanzahl eines Codes mit variabler Länge umfassen, an die Verschiebestufe die Länge jedes decodierten Codes zurücksendet und einen decodierten Wert jedes Codes erzeugt, wobei die logische Einheit ein Steuergerät (7) umfaßt, das mindestens zwei getrennte Bearbeitungseinheiten (8, 9) steuert, dadurch gekennzeichnet, daß eine erste Bearbeitungseinheit (8) die Länge jedes Codes entnimmt und sie an die Verschiebestufe adressiert und eine zweite Bearbeitungseinheit (9) die Decodierung der Codes vornimmt.

2. Decodiervorrichtung nach Anspruch 1, dadurch gekennzeichnet, daß der Datenfluß (2) eine Längentabelle der Codes enthält und das Steuergerät (7) aus dem Datenfluß (2) die Parameter entnimmt, die die Längentabelle der Codes definieren, und diese Tabelle an die erste Bearbeitungseinheit (8) adressiert.

3. Decodiervorrichtung nach einem der Ansprüche 1 und 2, dadurch gekennzeichnet, daß der Datenfluß (2) eine Decodiertabelle für die Codes mit variabler Länge enthält und das Steuergerät (7) aus dem Datenfluß (2) die Parameter entnimmt, die die Decodiertabelle für die Codes mit variabler Länge definieren, und diese an die zweite Bearbeitungseinheit (9) adressiert.

4. Decodiervorrichtung nach einem der Ansprüche 1 bis 3, dadurch gekennzeichnet, daß der Datenfluß (2) Bewegungsvektoren enthält und daß die Vorrichtung eine dritte Bearbeitungseinheit (17) umfaßt, die die Decodierung der Bewegungsvektoren vornimmt.

5. Decodiervorrichtung nach einem der Ansprüche 1 bis 4, dadurch gekennzeichnet, daß jede Bearbeitungseinheit (8, 9, 17) von dem Steuergerät (7) in einem Master/Follower-Verhältnis gesteuert wird, wobei das Steuergerät (7) einen Anfangsbefehl entsendet, um eine Bearbeitung in einer Bearbeitungseinheit (8, 9, 17) zu steuern, und wobei diese an das Steuergerät (7) ein Endsignal zurücksendet, wenn die Bearbeitung beendet ist.

6. Decodiervorrichtung nach einem der Ansprüche 1 bis 5, dadurch gekennzeichnet, daß jede Bearbeitungseinheit (8, 9, 17) die Daten, die von der Verschiebestufe kommen, zur gleichen Zeit empfängt, als diese von dem Steuergerät (7) erhalten werden.

7. Decodiervorrichtung nach einem der Ansprüche 1 bis 6, dadurch gekennzeichnet, daß das Steuergerät (7) die Entsendung der Signale nach der Decodierung steuert.

8. Decodiervorrichtung nach einem der Ansprüche 1 bis 7, dadurch gekennzeichnet, daß das Steuergerät (7) derart beschaffen ist, daß die erste Bearbeitungseinheit (8) die Länge jedes Codes entnimmt und sie an die Verschiebestufe adressiert, während die zweite Bearbeitungseinheit (9) die Decodierung vornimmt.

## Claims

1. A device for decoding a data stream (2) representing moving pictures encoded according to the MPEG standard in which a logical unit receives from an offset stage data containing the maximum number of bits in a variable length code, returns the length of each decoded code to the offset stage, and produces a decoded value of each code, the logical unit comprising a controller (7) controlling at least two separate processing units (8, 9), characterized in that a first processing unit (8) extracts the length of each code and addresses it to the offset stage, and a second processing unit (9) decodes the codes.

2. A decoding device according to claim 1, characterized in that the data stream (2) comprising a code length table, the controller (7) extracts from the data stream (2) parameters defining the code length table and addresses this table to the first processing unit (8).

3. A decoding device according to any one of claims 1 and 2, characterized in that the data stream (2) comprising a variable length code decoding table, the controller (7) extracts from the data stream (2) parameters defining the variable length code decoding table and addresses it to the second processing unit (9).

4. A decoding device according to any one of claims 1 to 3, characterized in that the data stream (2) comprising movement vectors, it comprises a third processing unit (17) to decode movement vectors.

5. A decoding device according to any one of claims 1 to 4, characterized in that each processing unit (8, 9, 17) is controlled by the controller (7) in a master/slave relation, the controller (7) addressing a start command to control processing in a processing unit (8, 9, 17), and the processing unit returning an end signal to the controller (7) when the processing is terminated.

6. A decoding device according to any one of claims 1 to 5, characterized in that each processing unit (8, 9, 17) receives data from the offset stage at the same time as the controller (7) receives the same data.

7. A decoding device according to any one of claims 1 to 6, characterized in that the controller (7) controls transmission of signals after decoding.

8. A decoding device according to any one of claims 1 to 7, characterized in that the controller (7) is such that the first processing unit (8) extracts the length of each code and addresses it to the offset stage, while the second processing unit (9) is decoding.
